# EUROPÄISCHE PATENTSCHRIFT

(11) **EP 1 549 855 B1**
(45) Veröffentlichungstag und Bekanntmachung des Hinweises auf die Patenterteilung: **15.08.2012**
(21) Anmeldenummer: 03798855.7
(22) Anmeldetag: 11.06.2003
(51) Int. Cl.: F04D 29/42, F04D 25/08, F02B 39/10

(54) **ELEKTRISCH BETRIEBENER LADELUFTVERDICHTER MIT INTEGRIERTER LUFTKÜHLUNG**
ELECTRICAL CHARGE AIR COMPRESSOR PROVIDED WITH AN INTEGRATED AIR COOLING SYSTEM
COMPRESSEUR ELECTRIQUE D'AIR DE SURALIMENTATION A REFROIDISSEMENT A AIR INTEGRE

(30) Priorität: 01.10.2002 DE 10245798
(43) Veröffentlichungstag der Anmeldung: 06.07.2005
(73) Patentinhaber: ROBERT BOSCH GMBH, 70442 Stuttgart (DE)
(72) Erfinder: BOLZ, Martin-Peter, 77815 Buehl (DE)
(86) Internationale Anmeldenummer: PCT/DE2003/001931
(87) Internationale Veröffentlichungsnummer: WO 2004/031590

(56) Entgegenhaltungen:
- EP-A- 0 650 690
- EP-A- 1 215 378
- DE-A- 2 117 929
- FR-A- 2 815 671
- US-A- 5 577 385
- US-A- 5 904 471
- US-A- 6 102 672

## Beschreibung

### Stand der Technik

Die Erfindung betrifft eine Vorrichtung zur Verdichtung von Verbrennungsluft, insbesondere einen elektrisch betriebenen Ladeluftverdichter mit den Merkmalen des Oberbegriffs des Anspruchs 1.

Es ist bekannt, die Leistungsdichte einer Brennkraftmaschine durch Verdichtung der zur Verbrennung des Kraftstoffes benötigten Luft mittels eines Abgasturboladers zu erhöhen. Der Abgasturbolader weist dabei eine Turbine auf, die im Abgasstrom des Verbrennungsmotors angeordnet ist und die einen, in der Ladeluftzuführung der Brennkraftmaschine angeordneten Verdichter antreibt.

Derartige Abgasturbolader weisen den bekannten Nachteil eines verzögerten und unzureichenden Ansprechverhaltens bei niedrigen Drehzahlen der Brennkraftmaschine auf ("Turboladerloch").

Zur Verbesserung der Ladeluftzuführung, speziell im Bereich niedriger Drehzahlen der Brennkraftmaschine, ist es bekannt, den Abgasturbolader mittels eines elektrischen Hilfsantriebes zu unterstützen. Dies kann beispielsweise durch einen, in den Abgasturbolader integrierten Elektromotor erreicht werden. Der Elektromotor treibt dann die Welle des Verdichters des Abgasturboladers bei niedrigen Drehzahlen der Brennkraftmaschine an. Ein solcher Hybrid-Antrieb des Abgasturboladers erfordert sowohl eine hohe Drehzahlbelastbarkeit des Elektromotors, als auch einen hohen elektrischen Leistungsbedarf aufgrund der hohen Massenträgheitsmomente der notwendigerweise hitzebeständigen, stahlausgeführten Turbine des Abgasturboladers. Darüber hinaus vergrößert sich das Einbauvolumen eines solchen Abgasturboladers durch die Integration des zusätzlichen Elektromotors.

Zur Vermeidung der Nachteile eines solchen Hybrid-Antriebes ist es beispielsweise aus der US 6,029,452 bekannt, einen separaten, rein elektrisch betriebenen Hilfslader (elektrischer Zusatzverdichter, EZV) in der Ladeluftzuführung einer Brennkraftmaschine in Reihe zu einem konventionellen, turbinengetriebenen Abgasturbolader zu betreiben. Dies hat den großen Vorteil, dass der separat zur Ladeluftzuführung eingesetzte, elektrische Zusatzverdichter auf einen kurzzeitigen Einsatz im untersten Drehzahlbereich der Brennkraftmaschine optimiert werden kann. Typischerweise wird der elektrische Zusatzverdichter dem Abgasturbolader seriell vorgeschaltet, so dass sich der erreichbare Ladedruck als Produkt der Einzeldruckwerte ergibt.

Aufgrund des kurzfristigen, sehr hochtourigen Betriebes des elektrischen Zusatzverdichters kommt es zu einer starken thermischen Belastung dieser Systemkomponente. Neben der passiven Ableitung der Überschusswärme ist es bekannt, den elektrischen Zusatzverdichter im Betrieb auch durch die angesaugte Ladeluft selbst zu kühlen. Zur aktiven Luftkühlung wird in der US 5,904,471 vorgeschlagen, den angesaugten Luftstrom zuerst am Motorgehäuse entlang bzw. direkt durch das Motorgehäuse hindurch zu leiten und anschließend dem Verdichterraum des Zusatzverdichters zuzuführen. Die Anordnung des Verdichterrades auf der der Ansaugöffnung entgegen gesetzten Seite des antreibenden Motors sowie die Durchleitung des Luftstromes durch den Motor selbst resultiert in einem erhöhten Strömungswiderstand für den passiven Ladeluftverdichter. Ein solches System hat den Nachteil eines geringeren Wirkungsgrades, der für den Ladedruck erreicht werden kann

Im Bereich hoher Drehzahlen der Brennkraftmaschine, die gleichzeitig zu einer hohen Drehzahl des Abgasturboladers und damit verbunden, einem hohen Durchsatz an Ladeluft allein aufgrund der Förderwirkung des Abgasturboladers führt, wird eine Bypass-Lösung genutzt, um die Ladeluft unter Umgehung des dann nicht mehr benötigten Zusatzverdichters direkt dem Kompressor des Abgasturboladers zuzuführen. Daher ist es erforderlich, dass der elektrische Zusatzverdichter in seinem passiven Betrieb einen möglichst geringen Strömungswiderstand der vom Abgasturbolader angesaugten Ladeluft aufweist.

Aus der US 5,904,471 ist bekannt, einen Bypass-Kanal in den elektrischen Zusatzverdichter zu integrieren. In der US 5,904,471 wird ein Klappenventil verwandt, welches den Ladeluftstrom in den Bypass-Kanal umlenkt, so dass dieses nicht über den Verdichtungsraum und das darin angeordnete Verdichterrad des elektrisch betriebenen Turboverdichters geleitet wird. Eine solche klappengesteuerte Bypass-Lösung ist jedoch hinsichtlich der strömungstechnischen Anforderungen an den Zusatzverdichter nicht optimal und unter Berücksichtigung der Anforderungen an Montage, Größe und Kosten des Gesamtsystems zur Ladeluftverdichtung sehr aufwändig und teuer.

Insbesondere ergeben sich bei einer Bypass-Lösung gemäß der US 5,904,471 erhöhte Strömungswiderstände im Zusatzverdichter, da unter Anderem im Strömungskanal durch das ausgebildete Klappenventil Ecken und Kanten vorhanden sind, die zu turbulenten Strömungsverhältnissen führen.

Aufgabe der Erfindung ist es, einen elektrischen Zusatzverdichter dahingehend weiter zu entwickeln, dass er sowohl im aktiven, als auch im passiven Betrieb eine Luftkühlung seiner Komponenten mit möglichst geringem Strömungswiderstand ermöglicht.

Die der Erfindung zugrunde liegende Aufgabe wird durch eine Vorrichtung zur Verdichtung von Verbrennungsluft mit den Merkmalen des Anspruchs 1 gelöst. Vorteilhafte Weiterbildungen und Ausführungsformen ergeben sich aus den in den Unteransprüchen aufgeführten Merkmalen.

### Vorteile der Erfindung

Der erfindungsgemäße, elektrisch angetriebene Ladeluftverdichter mit den Merkmalen des Anspruchs 1 vermeidet die im Stand der Technik auftretenden Nachteile und ermöglicht es, einen elektrischen Turboverdichter in der Ladeluftzuführung einer Brennkraftmaschine in Reihe mit beispielsweise einem Abgasturbolader zu betreiben, wobei der erfindungsgemäße Zusatzverdichter im aktiven als auch im passiven Betrieb luftgekühlt wird. In vorteilhafter Weise wird die Luftkühlung unter Vermeidung eines erhöhten Strömungswiderstandes des elektrischen Zusatzverdichters ermöglicht.

Die erfindungsgemäße Vorrichtung zur Verdichtung von Verbrennungsluft weist einen elektrisch betriebenen Lade luft verolichter gemäß Anspruch 1 auf.

Vorteilhafte Weiterbildungen und Ausführungsbeispiele der Erfindung werden durch die in den Unteransprüchen enthaltenen Merkmale ermöglicht.

Der Strömungskanal der verdichteten Ladeluft ist in dem erfindungsgemäßen Zusatzverdichter derart ausgestaltet, dass eine thermische Kopplung zwischen dem Strömungskanal und dem Elektromotor bzw. zwischen dem Strömungskanal und dem, den Elektromotor aufnehmenden, zweiten Gehäuseteil besteht.

In vorteilhafter Weise ist der zweite Gehäuseteil zumindest teilweise aus einem wärmeleitenden Material, beispielsweise aus einem Metall gebildet.

Eine kompakte und sehr gut wärmeleitende Ausführungsform des erfmdungsgemäßen Zusatzverdichters ergibt sich, wenn der Strömungskanal im Wesentlichen in dem zweiten Gehäuseteil selbst ausgebildet ist. In dem erfindungsgemäßen elektrischen Zusatzverdichter wird der schneckenförmig ausgebildete Verbindungskanal zwischen dem Verdichterraum des Verdichters und der Auslassöffnung des Verdichters gegenüber den Ausführungsformen des Standes der Technik in Richtung des antreibenden Elektromotors "umgeklappt". Die hängende, d.h. um das Gehäuse des Antriebs gewickelte, Volute (Verdichterschnecke) sorgt somit für eine optimale Kühlung von Motor und Elektronik. Erfahrungsgemäß ist eine besonders günstige Strömungsformung des luftführenden Gehäuses durch einen geraden, d.h. axialen Einlass und einen schneckenförmigen, am Umfang des Gehäuses angeordneten Auslass gekennzeichnet. In einem besonders vorteilhaften Ausführungsbeispiel des erfindungsgemäßen Zusatzverdichters ist der Strömungskanal (Volute) ein Teil des metallischen Motorgehäuses. Der hohe Luftmassenstrom durch die Volute sowohl im aktiven als auch im passiven Betrieb des Zusatzverdichters sorgt für eine optimale Kühlung des Metallkörpers, indem der Antriebsmotor für den Verdichter untergebracht ist. Neben dem antreibenden Elektromotor kann in dem Motorgehäuse zusätzlich auch ein Kompartment ausgebildet sein, welches zu kühlende Elektronikkomponenten der Motor- bzw. Verdichteransteuerung enthält.

In vorteilhafter Weise besitzt das Motorgehäuse einen geringeren Durchmesser als der Innendurchmesser des am Umfang des Verdichtergehäuses angeordneten Strömungskanals. Auf diese Weise ist es möglich, den Elektromotor bzw. das den Elektromotor aufnehmende Gehäuse vom Strömungskanal zumindest teilweise in axialer Richtung umschließen zu lassen, ohne das Bauvolumen des erfindungsgemäßen Verdichters zusätzlich zu vergrößern.

Die sehr kompakte Baugröße des erfindungsgemäßen Zusatzverdichters ergibt sich zudem auch dadurch, dass der Strömungskanal auf der Hochdruckseite des Verdichterrades angeordnet ist. Insbesondere lässt sich der Strömungskanal (Volute) auf der dem Einlasskanal abgewandten Seite des Verdichterrades anordnen. Durch diese Ausbildung des Strömungskanals lässt sich eine effektive Luftkühlung des Verdichtergehäuses bzw. des das Verdichterrad antreibenden Elektromotors erreichen, ohne dass eine spezielle Strömungsumlenkung für den Kühlungseffekt notwendig wäre. Vielmehr lässt sich die optimierte Strömungsführung in Form einer schneckenförmigen Volute in vorteilhafter Weise auch zur Gehäusekühlung verwenden.

Um den Strömungswiderstand des erfindungsgemäßen Zusatzverdichters auch im passiven Betriebsfall, d.h. bei abgeschaltetem Elektromotor, möglichst gering zu halten, weist der erfindungsgemäße Verdichter einen Bypass-Kanal auf, der den Einlasskanal des Verdichters direkt mit dem Strömungskanal (Volute) verbindet. Dadurch, dass der Strömungskanal über dem Bypasskanal mit dem Einlasskanal des Gehäuses verbindbar ist, ermöglicht die erfindungsgemäße Formgebung des Strömungskanals auch im passiven Betrieb einen großen Kühlungseffekt. Daher kann vorteilhafterweise kann im erfindungsgemäßen Zusatzverdichter sowohl im aktiven als auch im passiven Betrieb ein und derselbe Strömungskanal zur Kühlung der Komponente benutzt werden. In der passiven Betriebsart, die die überwiegende Betriebsart des elektrischen Zusatzverdichters repräsentiert, hat dieser nur die Aufgabe, den Luftstrom mit dem geringst möglichen Strömungswiderstand passieren zu lassen. Dabei kann die Komponente die vorbeiströmende Luft nutzen, um sich selber für den nächsten Einsatz auf eine möglichst niedrigere Betriebstemperatur zu bringen.

Der erfindungsgemäße Verdichter weist Mittel auf, die den BypassKanal bei aktiviertem Elektromotor verschließen. Eine einfache und zuverlässige Art, den Bypass-Kanal zu verschließen, besteht darin, den Drall der radial aus dem Verdichterrad strömenden Luft dazu zu nutzen, um über beispielsweise im Diffuser des Verdichters angeordnete Schaufeln den Bypass-Kanal zu verschließen. Dabei wird der Bypass-Kanal sowohl an seiner dem Einlasskanal des Verdichters zugewandten Seite, als auch an seiner, dem Strömungskanal (Volute) zugewandten Seite verschlossen. Durch das beidseitige Verschließen des Strömungskanals lassen sich in vorteilhafter Weise Luftverwirbelungen an den Eingängen des Bypasskanals und damit ein erhöhter Strömungswiderstand im aktiven Betrieb des Verdichters realisieren.

Die erfindungsgemäße Vorrichtung weist darüber hinaus Mittel, insbesondere elastische Mittel, auf, die den Bypass-Kanal bei deaktiviertem Elektromotor möglichst schnell und zuverlässig öffnen. Aufgrund des großen Strömungsquerschnittes des Bypass-Kanals stellt der erfindungsgemäße Zusatzverdichter im passiven Betriebsfall nur einen sehr geringen Strömungswiderstand dar. Dies ermöglicht auch im passiven Betriebsfall des Zusatzverdichters einen günstigen Wirkungsgrad des Gesamtsystems der Ladeluftzuführung bzw. des Verbrennungsmotors.

Die beanspruchte Vorrichtung zur Verdichtung von Verbrennungsluft ermöglicht einen elektrisch angetriebenen Zusatzverdichter für die Ladeluft eines Kraftfahrzeuges, der eine effiziente Kühlung, insbesondere eine Kühlung durch die angesaugte Ladeluft ermöglicht, ohne einen erhöhten Luftwiderstand darzustellen. Dadurch, dass die Luftkühlung sowohl im aktiven, als auch im passiven Betrieb des elektrischen Ladeluftverdichters möglich ist und in vorteilhafter Weise durch denselben Strömungskanal erfolgt, kann die thermische Belastung für solch einen hochtourig betriebenen, elektrischen Zusatzverdichter gering gehalten werden.

Weitere Vorteile der erfindungsgemäßen Vorrichtung sind in den nachfolgenden Zeichnungen sowie der zugehörigen Beschreibung eines Ausführungsbeispiels einer erfindungsgemäßen Vorrichtung zur Verdichtung von Verbrennungsluft zu entnehmen.

### Zeichnung

In der Zeichnung sind zwei Ausführungsbeispiele einer erfindungsgemäßen Vorrichtung zur Verdichtung von Verbrennungsluft dargestellt, welche in der nachfolgenden Beschreibung erläutert werden sollen. Die Figuren der Zeichnung, deren Beschreibung sowie die darauf gerichteten Ansprüche enthalten zahlreiche Merkmale in Kombination. Ein Fachmann wird diese Merkmale auch einzeln betrachten und zu sinnvollen, weiteren Kombinationen zusammen fassen.

Es zeigen:
- Figur 1: einen Querschnitt durch einen erfindungsgemäßen, elektrisch betriebenen Ladeluft-Verdichter in einer schematisierten Darstellung,
- Figur 2: einen Querschnitt durch eine alternative Ausführungsform eines erfindungsgemäßen Ladeluft-Verdichters bei geschlossenem BypassKanal,
- Figur 3: einen Querschnitt durch den Ladeverdichter gemäß Figur 2 bei geöffnetem Bypass-Kanal.

### Beschreibung der Ausführungsbeispiele

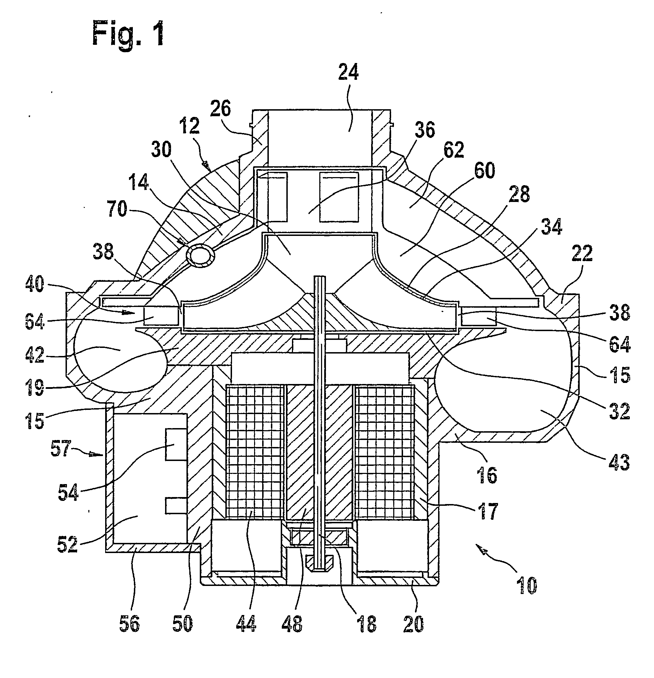

Figur 1 zeigt eine schematisierte Darstellung eines ersten Ausführungsbeispiels der erfindungsgemäßen Vorrichtung zur Verdichtung von Verbrennungsluft. Der Verdichter 10 weist ein Gehäuse 12 auf, welches im Ausführungsbeispiel der Figur 1 mehrteilig ausgebildet ist. Das Gehäuse des Verdichters umfasst im Wesentlichen einem ersten Gehäuseteil 14 für den eigentlichen Verdichterkopf 22 der Vorrichtung im Folgenden auch Verdichterteil der Vorrichtung genannt und einen zweiten Gehäuseteil 16, der die

Antriebsmittel für den Verdichter umgibt und im Ausführungsbeispiel der Figur 1 im Wesentlichen einen den Verdichter antreibenden Elektromotor 18 nebst zugehörigen Elektronikbausteinen beinhaltet. Der zweite Gehäuseteil 16 des Verdichters nach dem Ausführungsbeispiel der Figur 1 ist aus Fertigungsgründen in sich dreistückig aufgebaut. Der Gehäuseteil 16 umfasst das eigentliche Motorgehäuse 17 des antreibenden Elektromotor 18, welches als Poltopf beziehungsweise als Rohr ausgebildet ist, einen Diffuserring 19, der in axialer Richtung zwischen dem Verdichterkopf 22 und dem Motorgehäuse 17 angeordnet ist und ein dritten Gehäuseteil 15, welcher ein Kompartment 52 für Elektronikbausteine zur Ansteuerung des Verdichters und einen Teil des Strömungskanals des Verdichters enthält.

Darüber hinaus weist das Gehäuse 12 einen den Gehäuseteil 16 verschließenden Boden 20 auf, der einen leichten Zugang zum Motorteil der Vorrichtung ermöglicht und zudem auch ein Lager der Antriebswelle des Verdichterrades stützt.

Der Verdichterkopf 22 des Verdichters 10 ist als Radialverdichter mit axialer Ansaugung ausgebildet. Der erste Gehäuseteil 14 für den Verdichterkopf 22 besitzt eine glockenförmige bzw. trichterförmige Ausgestaltung mit einem Einlasskanal 24, der durch einen Einlassstutzen 26 des ersten Gehäuseteils 14 gebildet wird.

Im ersten Gehäuseteil 14 ist ein Verdichterraum 28 ausgebildet, in dem ein Verdichterrad 30 angeordnet ist. Das Verdichterrad 30 ist konzentrisch zum Einlasskanal 24 des ersten Gehäuseteils 14 des Verdichters 10 angeordnet. Das Verdichterrad 30 weist eine ebene Unterseite 32 auf, welches dem zweiten Gehäuseteil 16 des Verdichters 10 und insbesondere dem Diffusering 19 zugewandt ist. Die von der Unterseite 32 des Verdichterrades 30 abgewandte Oberseite des Verdichterrades ist in an sich bekannter Weise mit Verdichterstrukturen 34 in Form von dreidimensional ausgebildeten Schaufeln versehen. Vom Einlasskanal 24 des Verdichters 10 erstreckt sich ein erster Strömungskanal 36 in axialer Richtung des Verdichters in den Verdichterraum 28. Die durch den ersten Strömungskanal 36 im Betrieb des Verdichters angesaugte Ladeluft wird durch das Verdichterrad 30 beschleunigt und radial nach außen gedrückt. An seinen radialen Enden 38 geht der Verdichterraum 28 in einem Radialdiffuser 40 über. Der Radialdiffuser 40 wiederum mündet in einen Strömungskanal 42, der sich als Schnecke kontinuierlich am Umfang des Gehäuses 12 weitet und als Sammler für die verdichtete Ladeluft wirkt. An der Stelle, an der der schneckenförmige Strömungskanal 42

("Volute") in Umfangsrichtung des Verdichters auf seinen Anfang stößt, geht der Strömungskanal 42 tangential vom Gehäuse 12 des Verdichters weg. Der Radialdiffuser 40 endet ebenfalls tangential in dem Strömungskanal 42. Der Diffuserring 19, der somit auf seiner dem Verdichterrad 30 zugewandten Oberseite die Luft aus dem Verdichterrad in den Strömungskanal 42 überführt, wird dabei gleichzeitig durch diese Luft gekühlt. Dabei bildet er zusammen mit der Unterseite einer Steuerhaube 60 für einen Bypasskanal des Verdichters einen Ringdiffuser, der die Luftströmung verzögert und somit Druck aufbaut. Der Diffuserring 19 dient darüber hinaus gleichzeitig auch als Lagerschild für die Antriebswelle des Elektromotors 18.

Im Ausführungsbeispiel des erfindungsgemäßen Verdichters nach Figur 1 wird der in der Zeichnung obere, das heisst, der dem Verdichterkopf 22 zugewandte Teil des Strömungskanals 42 durch den ersten Gehäuseteil 14 des Verdichters und den Diffuserring 19 des Gehäuses 16 gebildet, so dass der Diffuserring 19 auch durch die Luft im Strömungskanal 42 gekühlt werden kann.

In der erfindungsgemäßen Vorrichtung ist der Strömungskanal 42 (Volute) in axialer Richtung umgeklappt und somit in Richtung auf den zweiten Gehäuseteil 16 des Elektromotors 18 ausgerichtet. (Üblicherweise schließt sich die Volute bei entsprechenden Verdichtern des Standes der Technik oberhalb eines Radialdiffusers, aber zur Saugseite hin gerichtet, an). Der Strömungskanal 42 gemäß dem Ausführungsbeispiel der Figur 1 ist in dem zweiten Gehäuseteil 16 des Verdichters 10 ausgebildet, welcher sich in axialer Richtung an das Verdichterrad anschließt. In vorteilhafter Weise besteht der zweite Gehäuseteil 16, welcher den, den Verdichter antreibenden Elektromotor 18 umgibt, aus einem gut wärmeleitenden Material. Insbesondere kann dieses Gehäuse aus einem Metall, beispielsweise Aluminium, gefertigt sein. Dieser Gehäuseteil umfasst den Strömungskanal 42 und einen Träger 52 für Elektronikbausteine 54 (Elektronikkompartment) des Antriebssystems. Die vorbei strömende Luft im Strömungskanal 42 kühlt dabei zum Einen über den Diffuserring 19 den Elektromotor 18 und zum anderen auch die Elektronikbausteine 54 im Elektronikkompartment 52.

Der Strömungskanal 42 des Verdichters kann in diversen Querschnittsformen ausgebildet sein. Vorteilhaft ist ein in etwa elliptischer Querschnitt. In dem in Figur 1 dargestellten Ausführungsbeispiel ist ein nur geringer Unterschied in den Größen der Halbachsen der elliptischen Querschnittsform vorhanden. In anderen Ausführungsbeispielen kann die Elliptizität ausgeprägter sein. So ist es beispielsweise auch möglich, den Strömungskanal 42 so auszubilden und anzuordnen, dass die große Halbachse der dem Kanal einzuschreibenden Ellipse parallel zur Antriebswelle des Verdichters verläuft. Auf diese Weise ist es möglich, das Motorgehäuse 17 großflächig durch den Luftstrom des Strömungskanals 42 zu kühlen. Der erfindungsgemäße Verdichter ist jedoch nicht auf die Verwendung einen elliptischen Querschnittprofils für den Strömungskanal 42 beschränkt. Kreisförmige oder andere Querschnittsformen sind ebenso möglich.

Der Antriebsmotor 18, der einen Stator 44 sowie einen, mit einer Antriebswelle 46 verbundenen Rotor 48 aufweist, ist derart ausgebildet, dass der Motor einen kleineren Durchmesser als der Innendurchmesser des Strömungskanals 42 besitzt. Auf diese Weise ist es möglich, dass der in Umfangsrichtung des Gehäuses 12 verlaufende, in Richtung des Elektromotors umgeklappte Strömungskanal 42 den Elektromotor 18 in Umfangsrichtung vollständig umgibt und in axialer Richtung zumindest teilweise umgreift.

Der dem Elektromotor 18 zugewandte, untere Teil des Strömungskanals 42 ist im Gehäuseteil 15 beziehungsweise 19 ausgearbeitet. Aus fertigungstechnischen Gründen ist das Gehäuse 16 mehrstückig ausgebildet. Der Gehäuseteil 15 enthält zudem den Träger 52 für die Elektronikbausteine der Motoransteuerung. Der hohe Luftmassenstrom im Strömungskanal 42 sorgt für eine optimale Kühlung des Metallkörpers 50 des Gehäuseteils 15. Die gute Wärmeleitfähigkeit des Metalls sorgt somit für eine gute Kühlung des Elektronik-Kompartments 52, welches in dem zweiten Gehäuseteil 15 ausgebildet ist. Zudem wird der Antriebsmotor 18 mit seinem Gehäuse 17, welches in radialer Richtung vom Gehäuseteil 15 umgeben ist, zusätzlich auch durch den Metallkörper 50 gekühlt.

In vorteilhafter Weise sind Elektronikbauelemente 54 der Leistungselektronik für die Ansteuerung des Elektromotors 18 bzw. für den Betrieb des Verdichters 10 in thermischen Kontakt mit dem Metallkörper 50 angebracht. Dazu können die elektronischen Bauelemente und insbesondere die eine hohe Verlustleistung erzeugenden Leistungshalbleiter mit oder auch ohne Wärmeleitmittel direkt an dem Gehäuseteil 15 befestigt sein. Auf diese Weise ist es möglich, einen guten Wärmeübergang, das heisst einen hohen Wärmefluss von den Elektronikbauteilen 54 in die Luft, die sich im Strömungskanal 42 befindet, zu realisieren. Das Elektronik-Kompartment 52 besitzt einen Deckel 56, welcher ggfls. durch entsprechende Öffnungen in seiner Aussenseite 57 für einen zusätzlichen Wärmeaustausch mit der Umgebung sorgen kann.

Der Gehäuseteil 17 des Elektromotors ist zudem, wie bereits beschrieben, thermisch stark an den Diffusering 19 und das Gehäuseteil 15 gekoppelt, so dass die vom Motor produziert Wärme auf diesem Wege gut abgeführt werden kann.

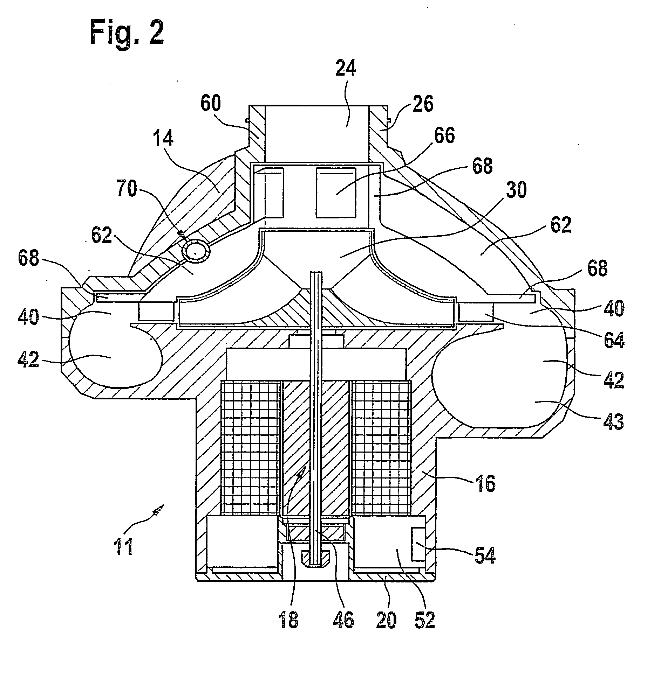

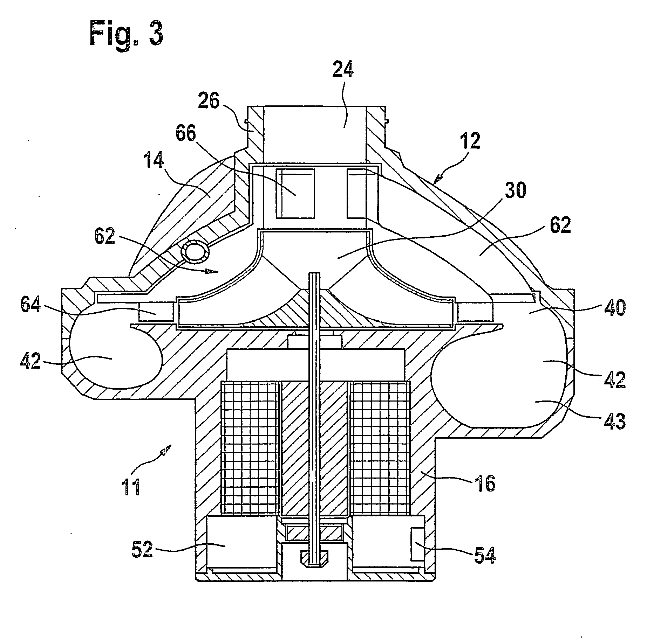

Figur 2 und 3 zeigen einen lediglich bezüglich des Antriebsmotors leicht modifizierten Verdichter 11. Im aktiven Betrieb des Verdichters 10 bzw. 11, treibt der Elektromotor 18 über die Antriebswelle 46 das Verdichterrad 30 im Verdichterraum 28 an. Im Ausführungsbeispiel der Figuren 2 und 2 ist das Gehäuse 16 des Verdichters 11 einstückig ausgebildet. Dies hat zwar fertigungstechnische Nachteile sorgt aber für eine optimale Kühlung sowohl des Motors 18, als auch der Elektronikbausteine 54 durch die Luft des Strömungskanals 42.

Die Anpassung an verschiedene Massenströme im aktiven bzw. im passiven Zustand des Verdichters 10 bzw. 11 erfolgt mittels einer Steuerhaube 60, die im ersten Gehäuseteil 14 zwischen dem Einlassstutzen 26 und dem Verdichterraum 28 des Verdichters glockenförmig angeordnet ist. Vom Einlassstutzen 26 zweigt in nahezu tangentialer Richtung ein Bypass-Kanal 62 ab, der eine Verbindung zwischen dem Einlasskanal 24 und dem Strömungskanal 42 ermöglicht. Der Bypass-Kanal 62 mündet dabei in den Ausgangsumfang des Radialdiffusers 40, der an dieser Stelle direkt in den Strömungskanal 42 übergeht.

Im Radialdiffuser 40 sind Schaufeln 64 angeordnet, die mit der Steuerhaube 60 in mechanischer Wirkverbindung stehen. Im aktiven Zustand des Verdichters 10 bzw. treibt der Drall der radial aus dem Verdichterrad 30 in den Radialdiffuser 40 strömenden, verdichteten Luft die Steuerhaube 60 mittels der im Diffuser stehenden Schaufeln 64 in die Drehrichtung des Verdichterrades. Die Steuerhaube 60 ist im Gehäuse 14 so gelagert, dass sie sich um einen definierten Winkel durch den Luftdrall dreht und dabei den Bypass-Kanal 62 durch das Verdrehen von Fenstern 66 oder entsprechenden anderen Schliesselementen 68 verschließt. Die angesaugte Verdichtungsluft gelangt in diesem Fall vom Einlassstutzen 26 direkt in den Verdichtungsraum 28, in dem es mit Hilfe des Verdichterrades 30 beschleunigt und somit verdichtet wird. Über den Strömungskanal 42 wird die Luft in Richtung des Auslasskanals 43 weitergeleitet. Dabei werden im erfmdungsgemäßen Verdichter 10 bzw. 11 beide Seiten des Bypass-Kanals 62, d.h. sowohl der dem Einlasskanal 24 zugewandte Anfang des Bypass-Kanals 62, als auch das dem Radialdiffuser 40 zugewandte Ende des Bypass-Kanals 62 durch die Schließelemente 68 bzw. durch das Verdrehen der Fenster 66 in der Steuerhaube 60 verschlossen. Auf diese Weise ist es möglich, eine Wirbelbildung, die sich beispielsweise an der Öffnung des Bypass-Kanals zum Radialdiffuser ausbilden könnte, zu vermeiden. Eine solche Wirbelbildung stellt einen erhöhten Strömungswiderstand dar und würde sich nachteilig auf die angestrebte günstige und damit verlustarme Strömung auswirken.

Die Steuerhaube 60 ist im Gehäuse 14 so gelagert, dass sie sich um einen definierten Winkel durch den an den Schaufeln 64 angreifenden Luftdrall dreht und dabei eine Federeinrichtung 70, die zwischen Steuerhaube 60 und dem Gehäuse 14 sitzt, spannt.

Ist der elektrische Antrieb 18 des Verdichters 10 bzw. 11 abgeschaltet, so sorgt die Federeinrichtung 70 für ein Rückstellmoment, das die Steuerhaube 60 zurück in ihre in Figur 3 dargestellte Ausgangsposition dreht und somit die Schließelemente 68 vor den Enden des Bypass-Kanals 62 entfernt und den Bypass-Kanal öffnet.

Figur 3 zeigt die erfindungsgemäße Vorrichtung bei geöffnetem Bypass-Kanal 62. Die beispielsweise durch den nachgeschalteten Abgas-Turbolader angesaugte Verdichterluft gelangt über den Einlasskanal 24 und den ersten Strömungskanal 36 in die Steuerhaube 60 des erfindungsgemäßen Verdichters und von dort über die Fensterelemente 66 in den nun geöffneten Bypasskanal 62. Aufgrund des großen Strömungsquerschnittes, sowohl im Einlasskanal 24, der Fenster 66 sowie in dem Bypass-Kanal 62 erfährt die den passiven Zusatzverdichter durchströmende Luft nur einen geringen Strömungswiderstand und gelangt nahezu ungehindert wiederum in den Strömungskanal 42 und von dort in den Auslass 43 des Verdichters 10 bzw. 11. Auf ihrem Weg durch den Strömungskanal 42 ermöglicht die angesaugte Luft eine effiziente Kühlung, insbesondere des zweiten Gehäuseteils 16 mit dem darin angeordneten Antriebsmotor 18. Der Verdichter 10 bzw. 11 kann in dieser passiven Betriebsart die vorbei strömende Luft nutzen, um sich selbst für den nächsten Einsatz auf eine möglichst niedrige Betriebstemperatur zu bringen.

Mit der beschriebenen Vorrichtung ist es in vorteilhafter Weise möglich, mit Hilfe der Ansaugluft eine Kühlung sowohl des antreibenden Elektromotors als auch der zugehörigen Elektronik eines elektrisch betriebenen Zusatzverdichters zu realisieren, ohne dabei auf die strömungstechnisch optimale Formgebung der Strömung der angesaugten Ladeluft zu verzichten. In beiden Betriebsarten können mit dieser Einrichtung günstige und damit verlustarme Strömungen ausgebildet werden, was in jedem Fall zu einem günstigeren Wirkungsgrad des Verbrennungsmotors mit zugehöriger Ladeluftzuführung führt. Durch die erfindungsgemäße Anordnung eines strömungstechnisch optimalen Strömungskanals ist es möglich, auch bei Verwendung eines Bypass-Kanals im passiven Betrieb des erfindungsgemäßen Verdichters eine optimale Kühlung der elektronischen Komponenten der Vorrichtung unter Beibehaltung möglichst großer Strömungsquerschnitte zu realisieren.

Der erfindungsgemäße, elektrisch angetriebene Ladeluftverdichter ist nicht auf das in den Zeichnungen präsentierte Ausführungsbeispiel beschränkt. Insbesondere ist die Vorrichtung nicht beschränkt auf die Verwendung lediglich eines einzelnen Verdichterrades.

## Patentansprüche

1. Elektrisch betriebener Ladeluftverdichter (10) mit einem Gehäuse (12), mit mindestens einem in einem Verdichterraum (28) eines ersten Gehäuseteils (14) angeordneten Verdichterrad (30), das in Strömungsrichtung zwischen einem Lufteinlass (24) und einem Luftauslass (43) des Gehäuses (12) angeordnet ist, mit einem in einem zweiten Gehäuseteil (16) des Gehäuses (12) angeordneten Elektromotor (18) zum Betrieb des Verdichterrades (30), sowie mit einem den Verdichterraum (28) mit dem Luftauslass (43) verbindenden, in Umfangsrichtung des ersten Gehäuseteils (12) verlaufenden Strömungskanal (42), der den Elektromotor (18) zumindest teilweise in axialer Richtung umgreift und in thermischer Verbindung mit dem Elektromotor (18) und dem zweiten Gehäuseteil (16) steht, wobei der Strömungskanal (42) über einen Bypasskanal (62) unter Umgehung des Verdichterrades (30) mit dem Lufteinlass (24) des Gehäuses (12) verbindbar ist, **dadurch gekennzeichnet, dass** Mittel (64, 68, 70) vorgesehen sind, die den Bypasskanal (62) durch eine im ersten Gehäuseteil (14) angeordnete, drehbar gelagerte Steuerhaube (60) bei aktiviertem Elektromotor (18) verschließen und bei deaktiviertem Elektromotor (18) öffnen.

2. Elektrisch betriebener Ladeluftverdichter (10) nach Anspruch 1, **dadurch gekennzeichnet, dass** Elektronikbausteine (54), insbesondere Elektronikbausteine der Motorelektronik des antreibenden Elektromotors (18), derart im zweiten Gehäuseteil (16) integriert sind, dass die Elektronik (54) überwiegend über den Strömungskanal (42) gekühlt wird.

3. Elektrisch betriebener Ladeluftverdichter (10) nach Anspruch 1 oder 2, **dadurch gekennzeichnet, dass** der zweite Gehäuseteil (16) zumindest teilweise aus einem wärmeleitenden Material besteht.

4. Elektrisch betriebener Ladeluftverdichter (10) nach einem der vorhergehenden Ansprüche, **dadurch gekennzeichnet, dass** der zweite Gehäuseteil (16) einen Diffusorring (19) aufweist, der einen Teil der Begrenzung des Strömungskanals (42) bildet und thermisch an den Elektromotor (18) gekoppelt ist.

5. Elektrisch betriebener Ladeluftverdichter (10) nach Anspruch 1, **dadurch gekennzeichnet, dass** der Strömungskanal (42) im Wesentlichen in dem zweiten Gehäuseteil (16) ausgebildet ist.

6. Elektrisch betriebener Ladeluftverdichter (10) nach Anspruch 5, **dadurch gekennzeichnet, dass** der Strömungskanal (42) einstückig mit dem zweiten Gehäuseteil (16) ausgebildet ist.

7. Elektrisch betriebener Ladeluftverdichter (10) nach einem der vorhergehenden Ansprüche, **dadurch gekennzeichnet, dass** der Strömungskanal (42) auf der dem Lufteinlass (24) abgewandten Seite des Verdichterrades (30) angeordnet ist.

8. Elektrisch betriebener Ladeluftverdichter (10) nach einem der vorhergehenden Ansprüche, **dadurch gekennzeichnet, dass** der Strömungskanal (42) einen sich in Umfangsrichtung des Gehäuses (12) weitenden Querschnitt aufweist.

9. Elektrisch betriebener Ladeluftverdichter (10) nach Anspruch 8, **dadurch gekennzeichnet, dass** der Strömungskanal (42) einen im Wesentlichen elliptischen Querschnitt aufweist, wobei die große Halbachse der Ellipse im Wesentlichen parallel zur Antriebswelle (46) des Elektromotors (18) verläuft.

10. Elektrisch betriebener Ladeluftverdichter (10) nach Anspruch 1, **dadurch gekennzeichnet, dass** die Mittel (64, 68) zum Schließen des Bypasskanals (62) als Schaufeln (64) eines in den Strömungskanal (42) mündenden Radialdiffusors (40) ausgestaltet sind, die mit der drehbar gelagerten Steuerhaube (60) derart in mechanischer Wirkverbindung stehen, dass sich die Steuerhaube (60) infolge des durch die Schaufeln (64) hervorgerufenen Luftdralls um einen definierten Winkel dreht und dabei den Bypasskanal (62) durch das Verdrehen von Schließelementen (68) verschließt.

11. Elektrisch betriebener Ladeluftverdichter (10) nach Anspruch 10, **dadurch gekennzeichnet, dass** die Mittel (70) zum Öffnen des Bypasskanals (62) als eine Federeinrichtung (70) ausgebildet sind, die sich bei Verdrehen der Steuerhaube (60) spannt, und bei deaktiviertem Elektromotor (18) infolge eines Rückstellmoments die Steuerhaube (60) zurück in ihre Ausgangsposition dreht.

## Claims

1. Electrically operated charge air compressor (10), having a housing (12), having at least one compressor wheel (30) which is arranged in a compressor chamber (28) of a first housing part (14) and which is arranged between an air inlet (24) and an air outlet (43) of the housing (12) as viewed in the flow direction, having an electric motor (18), which is arranged in a second housing part (16) of the housing (12), for operating the compressor wheel (30), and having a flow duct (42) which connects the compressor chamber (28) to the air outlet (43) and which runs in the circumferential direction of the first housing part (12) and which extends at least partially around the electric motor (18) in the axial direction and which is thermally connected to the electric motor (18) and to the second housing part (16), wherein the flow duct (42) can be connected to the air inlet (24) of the housing (12) via a bypass duct (62) bypassing the compressor wheel (30), **characterized in that** means (64, 68, 70) are provided which close the bypass duct (62) when the electric motor (18) is activated, and open the bypass duct (62) when the electric motor (18) is deactivated, by means of a control hood (60) arranged and rotatably mounted in the first housing part (14).

2. Electrically operated charge air compressor (10) according to Claim 1, **characterized in that** electronic components (54), in particular electronic components of the motor electronics of the driving electric motor (18), are integrated in the second housing part (16) such that the electronics (54) are cooled predominantly by means of the flow duct (42).

3. Electrically operated charge air compressor (10) according to Claim 1 or 2, **characterized in that** the second housing part (16) is composed at least partially of a heat-conducting material.

4. Electrically operated charge air compressor (10) according to one of the preceding claims, **characterized in that** the second housing part (16) has a diffuser ring (19) which forms a part of the delimitation of the flow duct (42) and which is thermally coupled to the electric motor (18).

5. Electrically operated charge air compressor (10) according to Claim 1, **characterized in that** the flow duct (42) is formed substantially in the second housing part (16).

6. Electrically operated charge air compressor (10) according to Claim 5, **characterized in that** the flow duct (42) is formed in one piece with the second housing part (16).

7. Electrically operated charge air compressor (10) according to one of the preceding claims, **characterized in that** the flow duct (42) is arranged on that side of the compressor wheel (30) which faces away from the air inlet (24).

8. Electrically operated charge air compressor (10) according to one of the preceding claims, **characterized in that** the flow duct (42) has a cross section which widens in the circumferential direction of the housing (12).

9. Electrically operated charge air compressor (10) according to Claim 8, **characterized in that** the flow duct (42) has a substantially elliptical cross section, wherein the large semiaxis of the ellipse runs substantially parallel to the drive shaft (46) of the electric motor (18).

10. Electrically operated charge air compressor (10) according to Claim 1, **characterized in that** the means (64, 68) for closing the bypass duct (62) are formed as blades (64) of a radial diffuser (40) which opens into the flow duct (42), which blades are mechanically operatively connected to the rotatably mounted control hood (60) such that the control hood (60) is rotated by a defined angle owing to the air swirl generated by the blades (64), and in so doing closes the bypass duct (62) as a result of the rotation of closing elements (68).

11. Electrically operated charge air compressor (10) according to Claim 10, **characterized in that** the means (70) for opening the bypass duct (62) are formed as a spring device (70) which is stressed when the control hood (60) rotates, and which, owing to a restoring torque, rotates the control hood (60) back into its initial position when the electric motor (18) is deactivated.

## Revendications

1. Compresseur (10) d'air de suralimentation entraîné électriquement, présentant :
un boîtier (12),
au moins une roue de compresseur (30) disposée dans un espace de compresseur (28) d'une première partie (14) du boîtier et disposée entre une admission d'air (24) et une sortie d'air (43) du boîtier (12) dans la direction d'écoulement,
un moteur électrique (18) disposé dans une deuxième partie (16) du boîtier (12) et qui entraîne la roue de compresseur (30) et
un canal d'écoulement (42) qui relie l'espace de compresseur (28) à la sortie d'air (43), qui s'étend dans la direction périphérique de la première partie de boîtier (12), qui chevauche au moins partiellement le moteur électrique (18) dans la direction axiale et qui est en communication thermique avec le moteur électrique (18) et la deuxième partie (16) du boîtier,
le canal d'écoulement (42) pouvant être relié par un canal de dérivation (62) à l'admission d'air (24) du boîtier (12) en contournant la roue de compresseur (30),
**caractérisé en ce que**
le compresseur présente des moyens (64, 68, 70) qui ferment le canal de dérivation (62) par un capot de commande (60), monté à rotation et disposé dans la première partie (14) du boîtier, lorsque le moteur électrique (18) est activé et qui l'ouvrent lorsque le moteur électrique (18) est désactivé.

2. Compresseur (10) d'air de suralimentation entraîné électriquement selon la revendication 1, **caractérisé en ce que** des modules électroniques (54), en particulier des modules électroniques de l'électronique du moteur électrique d'entraînement (18), sont intégrés dans la deuxième partie (16) du boîtier de telle sorte que l'électronique (54) soit refroidie principalement par l'intermédiaire du canal d'écoulement (42).

3. Compresseur (10) d'air de suralimentation entraîné électriquement selon la revendication 1 ou 2, **caractérisé en ce que** la deuxième partie (16) du boîtier est au moins en partie constituée d'un matériau thermiquement conducteur.

4. Compresseur (10) d'air de suralimentation entraîné électriquement selon l'une des revendications précédentes, **caractérisé en ce que** la deuxième partie (16) du boîtier présente un anneau diffuseur (19) qui forme une partie de la frontière du canal d'écoulement (42) et qui est couplée thermiquement au moteur électrique (18).

5. Compresseur (10) d'air de suralimentation entraîné électriquement selon la revendication 1, **caractérisé en ce que** le canal d'écoulement (42) est formé essentiellement dans la deuxième partie (16) du boîtier.

6. Compresseur (10) d'air de suralimentation entraîné électriquement selon la revendication 5, **caractérisé en ce que** le canal d'écoulement (42) est formé d'un seul tenant avec la deuxième partie (16) du boîtier.

7. Compresseur (10) d'air de suralimentation entraîné électriquement selon l'une des revendications précédentes, **caractérisé en ce que** le canal d'écoulement (42) est disposé sur le côté de la roue de compresseur (30) non tourné vers l'admission d'air (24).

8. Compresseur (10) d'air de suralimentation entraîné électriquement selon l'une des revendications précédentes, **caractérisé en ce que** le canal d'écoulement (42) présente une section transversale qui s'évase dans la direction périphérique du boîtier (12).

9. Compresseur (10) d'air de suralimentation entraîné électriquement selon la revendication 8, **caractérisé en ce que** le canal d'écoulement (42) présente une section transversale essentiellement elliptique, le grand demiaxe de l'ellipse étant essentiellement parallèle à l'arbre d'entraînement (46) du moteur électrique (18).

10. Compresseur (10) d'air de suralimentation entraîné électriquement selon la revendication 1, caractérisé en en ce que les moyens (64, 68) de fermeture du canal de dérivation (62) sont configurés sous la forme d'aubes (64) d'un diffuseur radial (40) qui débouche dans le canal d'écoulement (42) et qui coopère mécaniquement avec le capot de commande (60) monté à rotation de telle sorte que le capot de commande (60) tourne d'un angle défini suite au tourbillonnage de l'air provoqué par les aubes (64) et ferme ainsi le canal de dérivation (62) par rotation d'éléments de fermeture (68).

11. Compresseur (10) d'air de suralimentation entraîné électriquement selon la revendication 10, **caractérisé en ce que** les moyens (70) d'ouverture du canal de dérivation (62) sont configurés en dispositifs élastiques (70) qui se serrent lorsque le capot de commande (60) tourne et qui font retourner le capot de commande (60) dans sa position initiale suite à un couple de rappel lorsque le moteur électrique (18) est désactivé.
